# EUROPEAN PATENT APPLICATION

(11) **EP 3 045 385 A1**
(43) Date of publication of application: **20.07.2016**
(21) Application number: 15199541.2
(22) Date of filing: 11.12.2015
(51) Int. Cl.: B64C 1/06, B64C 1/18, H05K 9/00, B64D 11/00, B64C 1/40

(54) **TRANSPORT MACHINE**

(30) Priority: 19.01.2015 JP 2015007702
(71) Applicant: Mitsubishi Aircraft Corporation, Nishikasugai-Gun Aichi 480-0287 (JP)
(72) Inventor: Yokoi, Takashi, Aichi, 480-0287 (JP)
(74) Representative: Henkel, Breuer & Partner

(57) **Abstract**

The present invention provides a transport machine such as an aircraft (1), the transport machine including a compartment (11, 12) into which an electronic device (30) that generates an electromagnetic wave (W1) is carried. In the transport machine, an intra-compartment member (21, 22, 24) is at least one of a member (21, 22) defining an inside of the compartment (11, 12) and a member (24) disposed in the compartment (11, 12), and the intra-compartment member (21, 22, 24) includes an interior material (21) that constitutes an inner wall of the compartment (11, 12); and a floor material (22) that constitutes a floor of the compartment (11,12) or is provided on the floor. At least one of the interior material (21) and the floor material (22) includes a medium (21A, 22A) that absorbs the electromagnetic wave (W1).

## Description

### BACKGROUND OF THE INVENTION

### Field of the Invention

The present invention relates to countermeasures against electromagnetic waves emitted from electronic devices (PEDs: personal electronic devices) that are carried onboard a transport machine such as an aircraft.

### Description of the Related Art

It is necessary to ensure airworthiness of aircraft such that various devices including a navigation device and a communication device do not malfunction even in high intensity radiated fields (HIRF) due to electric waves emitted from a television station, a radio station, radar and satellite communication systems, or the like.

Thus, an opening portion (a window and a door) of an airframe, which works as a slot through which electromagnetic waves enter, is provided with an electromagnetic shielding member. For example, an electrically-conductive mesh that is formed by applying metal plating to a fiber fabric is held between window panels (JP 2003-523911A).

Various electronic devices such as computers provided in various communication devices or radio-navigation devices, and amusement devices are mounted on aircraft. Each of the electronic devices generates unintended unwanted harmonics (spurious waves) that are emissions such as harmonics as well as an intended electromagnetic wave such as a clock signal and a control signal.

Electronic devices mounted on aircraft, and an airframe are designed such that the mounted electronic devices do not electromagnetically interfere with each other, and the mounted electronic devices do not electromagnetically interfere with an antenna that is installed outside the airframe. However, there exists a potential risk of electromagnetic interference since various electronic devices carried onboard by passengers and crews are used at the same time in various places inside the aircraft.

Particularly, since an opening portion such as a window and a door of a fuselage is electromagnetically shielded, the inside of the fuselage becomes a cavity that is electromagnetically closed. If high intensity radiated fields are generated by cavity resonance of electromagnetic waves due to a standing wave, the risk of electromagnetic interference is increased.

That is, when electromagnetic waves emitted from the electronic devices carried onboard interfere with each other, operations of the mounted devices of the aircraft are possibly affected. Examples of the electronic devices carried onboard include a portable terminal, a CD player, a DVD player, a digital camera, and a game machine, which are personal electronic devices (PEDs) wirelessly connected to Bluetooth (Registered trademark), wireless radio communication, or Wi-Fi(Registered trademark). The examples also include an EFB (electronic flight bag) that is used in a cockpit, and an Active IC-TAG that is attached to an international cargo container in a cargo compartment.

Thus, an object of the present invention is to inhibit electromagnetic interference by electronic devices carried onboard.

### SUMMARY OF THE INVENTION

A transport machine of the present invention includes a compartment into which an electronic device that generates an electromagnetic wave is carried, wherein an intra-compartment member that is at least one of a member defining an inside of the compartment and a member disposed in the compartment includes an interior material that constitutes an inner wall of the compartment, and a floor material that constitutes a floor of the compartment or is provided on the floor, and at least one of the interior material and the floor material includes a medium that absorbs the electromagnetic wave.

One example of the transport machine is an aircraft. In this case, an airframe of the aircraft includes the above-mentioned compartment.

As the electronic device that generates an electromagnetic wave, there is one that uses, for example, Bluetooth (Registered trademark), wireless, or Wi-Fi (Registered trademark) communication. Electromagnetic energy of the electromagnetic wave radiated from the electronic device that is carried into the compartment by a passenger or a crew is converted into thermal energy by the medium included in the intra-compartment member and is thereby lost while the electromagnetic wave is reflected, for example, several times by a skin in an airframe structure positioned outside a wall of the compartment, and a floor panel typically formed of a carbon fiber reinforced resin. Therefore, a resonance phenomenon due to the electromagnetic wave in the compartment can be suppressed.

Examples of the intra-compartment member defining the inside of the compartment include an interior panel (a liner), a floor panel, a floor mat, and a floor carpet.

Also, examples of the intra-compartment member disposed in the compartment include a curtain that partitions a cabin space by seat class, a sunshade that is installed in a window, and a seat.

In accordance with the present invention, since an interference path loss (IPL) based on an absorption loss by the medium of the intra-compartment member is large, it is possible to inhibit electromagnetic interference such as front door coupling to an outboard antenna due to an electromagnetic wave leaking out of the aircraft through an opening portion such as a window, and back door coupling to an electronic device mounted onboard or a cable.

Particularly, when the airframe includes an opening defining member that defines an opening communicating with an outside of the aircraft, and an electromagnetic shielding member that is disposed in the opening to block the electromagnetic wave, or a seal member that is interposed between a closing member that closes the opening and the opening defining member and is given electrical conductivity, a risk of the front door coupling is increased by cavity resonance described later. Thus, the inhibition of electromagnetic interference by the present invention is of great significance.

Preferably, both of the interior material and the floor material include the medium, and a space in the compartment is surrounded by the medium included in the interior material and the floor material. The electromagnetic wave emitted in the compartment can be efficiently absorbed by the medium that surrounds the space in the compartment.

The medium in the present invention preferably contains ferrite or carbon.

Examples of the compartment in the present invention include a cabin in which a passenger stays, an aisle through which a passenger and a crew pass, a cockpit in which a pilot controls the aircraft, and a cargo compartment into which cargo is loaded. The intra-compartment member regarding a single or a plurality of compartments selected from the above compartments can be configured to include the medium.

The examples of the compartment in the present invention also include a crew rest room, a galley, and a toilet.

In the present invention, examples of the intra-compartment member defining the inside of the compartment include the interior material and the floor material.

The interior material is typically an electrical insulator having a sandwich structure formed by using a fiber reinforced resin (a composite material) containing glass fibers as reinforcing fibers. A skin in an airframe structure disposed outside the interior material is typically a conductor formed by using a metal material or a fiber reinforced resin containing carbon fibers as reinforcing fibers.

Since the interior material is an insulator, the interior material transmits the electromagnetic wave almost without a loss when left as it is. Thus, it is preferable the absorption loss is applied to the electromagnetic wave entering the interior material by configuring the interior material to include the medium that absorbs the electromagnetic wave.

An interior material having a sandwich structure is preferably employed as the interior material.

The interior material can be configured such that the sandwich structure includes a first layer, a second layer that is disposed outside the first layer, and a third layer that is disposed outside the second layer, the first layer transmits the electromagnetic wave, and at least the second layer out of the second and third layers includes the medium and absorbs the electromagnetic wave.

In a case in which the skin in the airframe structure is not formed of a metal material, but is formed of GFRP or a composite material (a fiber reinforced resin) having no electrical conductivity, the third layer is preferably configured to reflect the electromagnetic wave.

By adjusting a thickness of the third layer that reflects the electromagnetic wave, a phase of a reflected wave by the skin after the electromagnetic wave is transmitted through the third layer is delayed by 180° from a phase of a reflected wave by the third layer. Accordingly, the reflected wave by the third layer and the reflected wave by the skin may be canceled by each other.

Mixture ratios of fine particles of ferrite or carbon as the medium can be individually set for the first layer, the second layer, and the third layer. Accordingly, the respective layers can be provided with a function of transmitting the electromagnetic wave, a function of absorbing the electromagnetic wave, or the like.

A panel including the medium that absorbs the electromagnetic wave, and a metal sheet disposed along an outer peripheral surface of the panel, which are integrated together, can be also used as the interior material. Since the electromagnetic wave radiated from the PED and transmitted through the panel is reflected by the metal sheet, the metal sheet corresponds to the above third layer that reflects the electromagnetic wave.

The interior material including an electromagnetic wave reflecting material such as the metal sheet as described above is also suitable for the case in which the skin in the airframe structure is formed of GFRP or a composite material (a fiber reinforced resin) having no electrical conductivity. Also, by adjusting a thickness of the electromagnetic wave reflecting material, a phase of a reflected wave by the skin after the electromagnetic wave is partly transmitted through the electromagnetic wave reflecting material is delayed by 180° from a phase of a reflected wave by the electromagnetic wave reflecting material. Accordingly, the reflected wave by the electromagnetic wave reflecting material and the reflected wave by the skin may be canceled by each other.

The floor panel constituting the floor material is typically a conductor formed as a sandwich panel by using a fiber reinforced resin containing carbon fibers as reinforcing fibers.

The absorption loss may be applied to the electromagnetic wave entering the floor material by configuring a surface portion positioned inside the compartment in the floor panel as the conductor to include the medium. That "the medium is included in the surface portion" of the floor panel encompasses that the medium is included in a carpet or mat that covers the surface of the floor panel.

Examples of the carpet include a carpet where carbon or electrically-conductive polymer is formed on a fiber surface, and a carpet that is itself formed of carbon fiber union cloth.

Also, examples of the mat include a mat of rubber or the like impregnated with carbon or ferrite.

When the transport machine of the present invention is an aircraft, the airframe of the aircraft preferably includes a cable to which the electronic device is connected, a clamp that holds the cable, and a medium that is provided inside the clamp to absorb the electromagnetic wave.

Accordingly, an electromagnetic wave conducted to the cable through an electric outlet or the like from the electronic device carried into the compartment is absorbed by the medium included in the clamp that holds the cable. Thus, electromagnetic interference by conduction can be also inhibited. An interior material of the present invention defines an inside of a compartment in a transport machine (e.g. an aircraft) into which an electronic device that generates an electromagnetic wave is carried, and includes a medium that absorbs the electromagnetic wave.

A floor material of the present invention defines an inside of a compartment in a transport machine (e.g. an aircraft) into which an electronic device that generates an electromagnetic wave is carried, is specifically a floor panel constituting a floor of the compartment, or a floor mat or a floor carpet provided on the floor, and includes a medium that absorbs the electromagnetic wave.

In accordance with the present invention, it is possible to inhibit the electromagnetic interference by the electronic device that is carried onboard the transport machine such as the aircraft, and ensure a normal operation of the transport machine.

### BRIEF DESCRIPTION OF THE DRAWINGS

FIG. 1 is a cross-sectional view of a cabin of an aircraft according to a first embodiment;
FIG. 2 is a cross-sectional view of a cockpit of the aircraft according to the first embodiment;
FIG. 3 is a view illustrating a state in which an electromagnetic wave is reflected inside an airframe;
FIG. 4 is a view illustrating a section of an interior material having a sandwich structure and one example of a course of the electromagnetic wave; and
FIG. 5A is a view illustrating a cable and a clamp according to a second embodiment, and FIG. 5B is a view illustrating a ferrite core incorporated in the clamp.

### DETAILED DESCRIPTION OF THE PREFERRED EMBODIMENTS

In the following, embodiments of the present invention will be described by reference to the accompanying drawings.

### [First Embodiment]

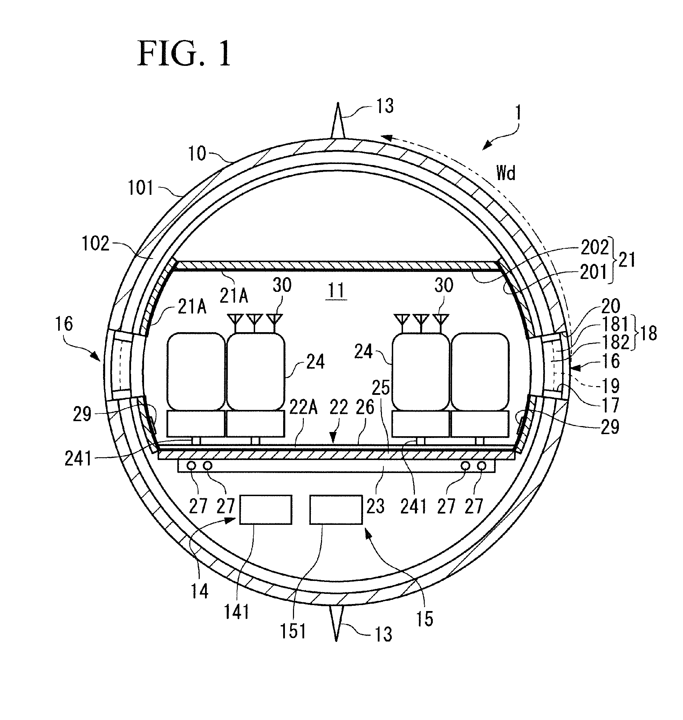

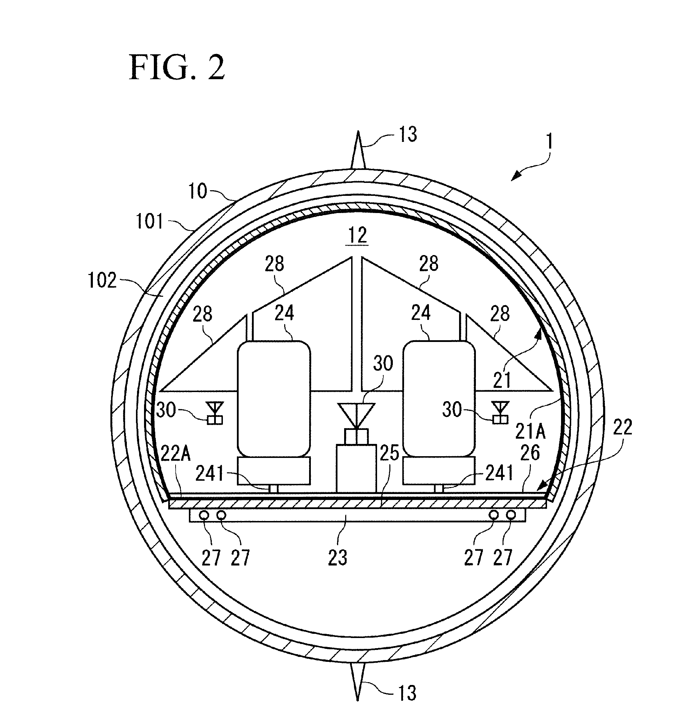

An aircraft 1 includes a cabin 11 shown in FIG. 1, a cockpit 12 shown in FIG. 2, and a cargo compartment (not shown) inside a fuselage 10. All of the cabin 11, the cockpit 12, and the cargo compartment are pressurized compartments.

As structural members, the fuselage 10 includes a skin 101 that forms a surface of the fuselage 10, annular frames 102 that support the skin 101 from a back side, and stringers (not shown) that are provided on a back surface of the skin 101.

The structural members of the fuselage 10 can be formed of a metal material such as aluminum alloy, a carbon fiber reinforced resin (CFRP: carbon fiber reinforced plastics) containing carbon fibers, or the like.

An outboard antenna 13 is installed outside the fuselage 10. A plurality of outboard antennas 13 are provided on each of an upper portion and a lower portion of the fuselage 10.

A communication system 14 provided in the aircraft 1 includes a computer device 141 that is installed onboard, and a predetermined outboard antenna 13, and performs radio communication with a ground control station or other aircraft via the outboard antenna 13.

A navigation system 15 provided in the aircraft 1 also includes a computer device 151 that is installed onboard, and a predetermined outboard antenna 13, and obtains a direction, a distance, an altitude, or the like required for a flight to a destination through radio communication between the outboard antenna 13 and a ground-based navigation aid.

The aircraft 1 is equipped with a plurality of systems in addition to the communication system 14 and the navigation system 15. Electronic devices constituting the respective systems are mounted onboard.

The cabin 11 is a compartment that is defined in a predetermined range of the fuselage 10 to allow passengers to stay.

The cabin 11 is provided with a plurality of windows 16 that are positioned in side surfaces of the fuselage 10, and a door (not shown). Openings 17 corresponding to the windows 16 and the door are formed in the skin 101. Window members 18 are disposed inside the openings 17 corresponding to the windows 16.

Each of the window members 18 is a laminate composed of a plurality of window panels 181 and 182. The window panels 181 and 182 can be formed of a resin material such as acrylic and polycarbonate.

In order to avoid a problem that electromagnetic waves emitted from ground facilities are transmitted through the window panels 181 and 182 to electromagnetically interfere with the electronic devices mounted onboard, an electromagnetic shielding layer 19 is interposed between the window panels 181 and 182. The electromagnetic shielding layer 19 is formed in a mesh shape by applying metal plating to a fiber fabric. Thus, the electromagnetic shielding layer 19 is called an electrically-conductive mesh.

A micro opening exists between fibers of the electrically-conductive mesh. The electromagnetic shielding layer 19 blocks an electromagnetic wave whose half wavelength is larger than dimensions of the opening.

A thin film that is formed of a metal material such as gold and silver, or ITO (indium tin oxide), a printed mesh that is formed by printing, in a mesh shape, ink containing an electrically-conductive filler on a substrate formed of a transparent resin material, an expanded metal that is formed by punching a metal sheet, or the like may also be used instead of the electrically-conductive mesh.

The electromagnetic shielding layer 19 may have any configuration as long as the electromagnetic shielding layer 19 has electrical conductivity, and optical transparency of a window member 18 is ensured.

A seal member 20 that is formed of a rubber material seals a gap between an inner periphery of the opening 17 and an outer periphery of the window member 18. It is preferable that electrical conductivity is given to the seal member 20 since electromagnetic waves entering the gap can be absorbed and attenuated by the seal member 20. For example, by mixing an electrically-conductive filler of carbon, metal or the like into a material of the seal member 20, electrical conductivity can be given to the seal member 20.

An opening (not shown) corresponding to the door of the cabin 11 is closed by a door member that is formed of metal, CFRP, or the like. In order to avoid a problem that a gap between the door member and the skin 101 works as a slot through which electromagnetic waves enter, an electromagnetic shielding layer is preferably formed on a seal member that is interposed between the gap. For example, a film where a metal thin film as the electromagnetic shielding layer is formed on a substrate may be attached to a surface of the seal member.

An interior material 21 constituting a wall (including a ceiling), and a floor material 22 constituting a floor define the inside of the cabin 11.

The interior material 21 has a wall panel 201 that rises from the floor material 22, and a ceiling panel 202 that faces the floor material 22. The wall panel 201 is disposed on each of a port side and a starboard side of the fuselage 10.

The wall panel 201 covers the back surface of the skin 101, and is provided on the stringers positioned on the back surface of the skin 101.

The ceiling panel 202 is disposed so as to connect the right and left wall panels 201, and faces the back surface of the skin 101. Accessories (not shown) or the like are disposed between the ceiling panel 202 and the skin 101.

Both of the wall panel 201 and the ceiling panel 202 can be formed of a glass fiber reinforced resin (GFRP: glass fiber reinforced plastics) containing glass fibers, or the like.

Each of the wall panel 201 and the ceiling panel 202 includes a medium 21A that absorbs an electromagnetic wave in a high-frequency band of, for example, 100 MHz to 18 GHz. The high-frequency band corresponds to a band in which PEDs and T-PEDs (transmit PEDs) are used. A T-PED means a portable terminal or a personal computer that perform communication through Wi-Fi (Registered trademark), LAN, or the like.

A space in the cabin 11 is surrounded by the medium 21A that exists over an entire surface, or a substantially entire surface of each of the wall panel 201 and the ceiling panel 202.

The medium 21A takes in electromagnetic energy based on at least one of a dielectric loss, a magnetic loss, and an electrically-conductive loss (a resistive loss), converts the electromagnetic energy to thermal energy and consumes the thermal energy therein.

A thin film containing a ferromagnetic material represented by ferrite, soft-magnetic metal, or carbon is formed as the medium 21A that absorbs the electromagnetic wave by plating, vapor deposition or the like on a front surface (a surface positioned on an aircraft inner side) of the interior material 21 of the present embodiment. The thin film is preferably formed on the entire front surface of the interior material 21. Examples of the soft-magnetic metal include alloy containing iron and cobalt, and alloy containing iron and nickel.

A material and a film thickness of the medium 21A can be appropriately determined according to the frequency band of the electromagnetic wave to be absorbed, and in consideration of flame retardancy required for onboard members as well.

Although not shown in the drawings, a fore wall and an aft wall of the cabin 11 are also composed of panels similar to the wall panel 201. It is preferable to form a medium similar to the above medium 21A on the panel interior materials as well.

The floor material 22 is installed inside the fuselage 10 as a member on which seats 24 are installed.

The floor material 22 includes floor beams 23, seat rails 241, a floor panel 25, and a floor carpet 26.

The floor beams 23 extend in a right-left direction to be coupled to the frames 102 of the fuselage 10.

The seat rails 241 extend in a longitudinal direction to support the seats 24.

For example, the floor beams 23 and the seat rails 241 can be formed of a metal material having high specific strength, such as aluminum alloy and titanium alloy, and CFRP.

The floor panel 25 is provided between right and left walls in the cabin 11. Cables 27 that include a power supply line for supplying electric power to various devices mounted on the aircraft 1 and a signal line for transmitting and receiving signals between devices, and pipes (not shown) that supply a hydraulic pressure to a driving unit of a flight control surface, and supply bleed air to an air-conditioner are provided in a space below the floor panel 25. The cables 27 and the pipes are passed through openings formed in the floor beams 23.

The floor panel 25 has a structure in which a honeycomb core is sandwiched between thin plates in order to achieve high stiffness at light weight. As a material of the floor panel 25, CFRP or the like can be used. Aluminum alloy or the like may also be used.

The floor carpet 26 is provided over an entire front surface of the floor panel 25.

In the present embodiment, the floor material 22 also includes a medium 22A that absorbs an electromagnetic wave in a high-frequency band of, for example, 100 MHz to 18 GHz similarly to the interior material 21 (the wall panel 201 and the ceiling panel 202).

A thin film containing ferrite, soft-magnetic metal, or carbon is formed as the medium 22A that absorbs the electromagnetic wave by plating, vapor deposition or the like on the front surface of the floor panel 25 of the present embodiment. The thin film is preferably formed on the entire front surface of the floor panel 25.

As for the cockpit 12 shown in FIG. 2, it is also preferable to employ an electromagnetic shielding layer or a seal member given electrical conductivity for a windshield 28 that is an opening portion provided in the compartment, and configure the interior material 21 and the floor material 22 to include the media 21A and 22A that absorb the electromagnetic waves similarly to the cabin 11.

Portable electronic devices that operate in the high-frequency band are carried onboard by passengers and crews. Examples of electronic devices (PEDs: personal electronic devices) 30 include a notebook or tablet personal computer (PC), a mouse wirelessly connected to the PC, a mobile phone, a smartphone, a game machine, a digital camera, a video camera, a music/video player such as a CD (compact disc) player and a DVD (digital versatile disk) player, a headphone wirelessly connected to the music/video player, and an electronic toy.

Formerly, onboard use of the PEDs was prohibited even during cruising except for an electronic device that generates no electric wave (no electromagnetic wave) during operation, such as a digital camera and a CD player, and an electronic device (a PC, a game machine, or the like) in a state in which a function of generating an electric wave is stopped. However, because of recent easing of regulations, use of the PEDs is widely permitted.

At present, onboard use of not only radio communication between onboard electronic devices such as between a mouse and a PC and between a headphone and a CD player, but also radio communication such as a phone call and internet connection with the outside of the aircraft using a PC, a mobile phone, a smartphone, and a game machine are permitted at all times as long as the devices are set to a flight mode, and the communication is performed via onboard radio equipment (Wi-Fi(Registered trademark), Bluetooth (Registered trademark), or the like).

Various frequencies are used in the PEDs 30 that are used onboard, and various types of communication standards also exist.

As one example, a frequency band in which a mobile phone is used is, for example, 0.8 GHz to 2.0 GHz. As for wireless LAN (IEEE 802.11), a 2.45 GHz band and a 5.2 GHz band are used. As for Bluetooth (Registered trademark) (IEEE 802.15.1), a 2.4 GHz band is used.

Since the variety of PEDs 30 as described above are used by passengers and crews in various places inside the aircraft, there exists a potential risk of electromagnetic interference due to electromagnetic waves radiated from the PEDs 30.

Objects to which the electromagnetic waves radiated from the PEDs 30 are coupled are as follows:
(1) the outboard antennas 13;
(2) the electronic devices mounted on the aircraft 1 (regardless of whether they generate electric waves or not); and
(3) the cables 27 for power supply and signal transmission.

The electronic devices of (2) include the computer device 141 of the communication system 14 and the computer device 151 of the navigation system 15.

In addition to the above coupling by radiation, there is coupling by conduction from the PEDs 30 that are connected to an airframe. The conduction coupling may occur, for example, when the PEDs 30 (a PC or the like) are wire-connected to a power outlet 29 that is provided around the seat of the airframe. Electromagnetic waves emitted from the PEDs 30 that are connected to the power outlet 29 may be coupled by conduction to the cables 27 installed below the floor material 22 as described later.

In the present embodiment, the radiation coupling and its countermeasures will be described.

The electromagnetic waves radiated from the onboard PEDs 30 are coupled to the outboard antennas 13 of (1) through the opening portions such as the windows 16, the door, and an access panel of the airframe directly or by reflection, diffraction, or scattering. This type of coupling is called front door coupling. FIG. 1 shows an example of a diffracted wave Wd that travels along a curve of the fuselage 10.

The electromagnetic waves emitted from the onboard PEDs 30 are also transmitted through a gap between onboard partition walls or between portion panels constituting the floor panel 25 to be directly coupled to the mounted electronic devices and the cables. This type of coupling is called back door coupling.

Intended electromagnetic waves such as a clock signal and a control signal obtained by dividing the clock signal, and unintended electromagnetic waves that are emissions (spurious emissions) such as harmonics that are integer multiples of frequencies of the intended electromagnetic waves are generated from the PEDs 30.

The front door coupling includes a case in which the unintended electromagnetic waves from the PEDs 30 interfere within a reception band of the outboard antennas 13, and a case in which the intended electromagnetic waves from the PEDs 30 interfere outside of the reception band of the outboard antennas 13. The front door coupling causes a decrease in reception quality of the outboard antennas 13 and a trouble in the outboard antennas 13.

On the other hand, the back door coupling is caused by the intended electromagnetic waves or the unintended electromagnetic waves from the PEDs 30, and causes a trouble in the mounted electronic devices when the electromagnetic waves exceed tolerance of the mounted electronic devices.

First, prevention of the front door coupling in order to ensure normal operations of the communication system 14 and the navigation system 15 that process data received by the outboard antennas 13 will be described.

When countermeasures, such as the electromagnetic shield in the window panels, are taken for the opening portions such as the windows 16 and the door based on a need for airworthiness against an HIRF environment, entering and exiting of electromagnetic waves into and out of the airframe through the opening portions are suppressed. Thus, a certain effect of avoiding coupling of the electromagnetic waves from the onboard PEDs 30 to the outboard antennas 13 can be obtained.

However, when the countermeasures, such as the electromagnetic shield, are taken for the opening portions, the inside of the fuselage 10 becomes a cavity with no outlet for electromagnetic waves. Thus, when the electromagnetic waves are repetitively reflected in the cavity, cavity resonance possibly occurs in a case in which wavelengths of the electromagnetic waves are resonant with dimensions of the cavity. Alternatively, in a case in which the wavelengths of the electromagnetic waves are resonant with a positional relationship of the structural members (for example, the frames 102) forming the cavity or the accessories (for example, the seat rails 241) in the cavity, or a case in which the wavelengths of the electromagnetic waves are close to each other, phases of the electromagnetic waves are aligned, so that resonance possibly occurs.

Even though the individual PEDs 30 emit weak electromagnetic waves, an electromagnetic wave field intensity in the fuselage 10 may be increased by resonance that unexpectedly occurs when the variety of PEDs 30 are used at the same time. In this case, the electromagnetic waves may leak from the opening portions, so that a risk of the front door coupling is increased.

There exist, in a complex manner, too many conditions to be grasped, such as that the PEDs 30 are used by an unspecified large number of passengers and crews inside the aircraft, that electromagnetic wave sources are moved along with movement of passengers and crews who carry the PEDs 30, arrangement of the airframe structural members, the accessories, and the electronic devices mounted on the airframe, positions of the cables 27, and shielded states of the cables 27. Thus, it is difficult to identify a cause of the occurrence of the electromagnetic wave resonance in the fuselage 10, and reproducibility is also poor.

In the present embodiment, as effective countermeasures for avoiding the front door coupling of the electromagnetic waves from the inside of the fuselage 10 where the opening portions are electromagnetically shielded as described above, the interior material 21 and the floor material 22 include the media that absorb the electromagnetic waves in the high-frequency band as described above.

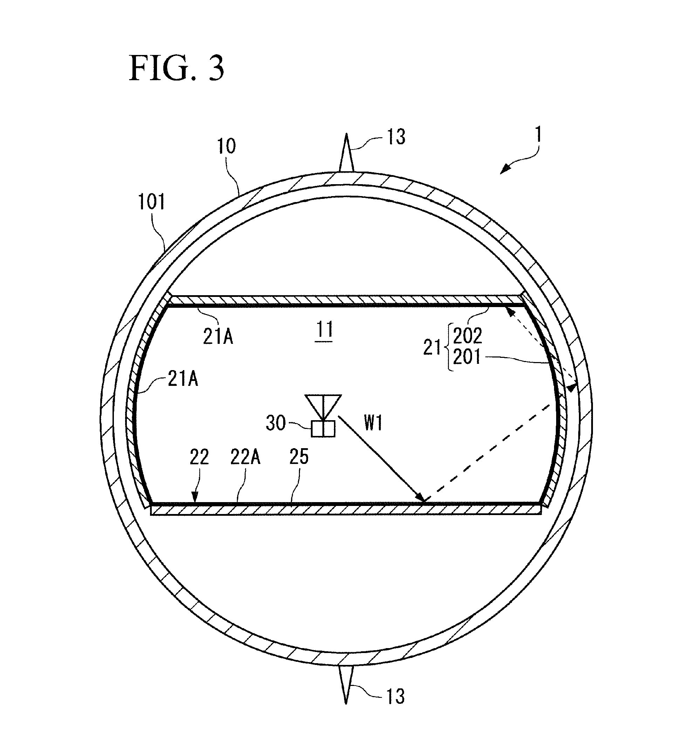

Accordingly, a loss of the electromagnetic waves in an interference path (IPL: interference path loss) from the onboard PEDs 30 to the outboard antennas 13 as an object of interference is increased, so that the electromagnetic waves can be attenuated. In the following, this point is described by reference to FIG. 3.

FIG. 3 shows one example of paths of the electromagnetic waves radiated from the PEDs 30. An electromagnetic wave W1 radiated from the PED 30 inside the aircraft such as the cabin 11 and the cockpit 12 and entering the floor material 22 is partly absorbed by the medium 22A at a top layer of the floor panel 25. A remaining portion that is transmitted through the medium 22A enters a base material of the floor panel 25 (made of CFRP or aluminum alloy). The electromagnetic wave W1 is reflected toward the aircraft inner side by the base material of the floor panel 25 that is a conductor. At this time, the electromagnetic wave W1 is partly absorbed by the medium 22A again at the top layer of the floor panel 25, and a remaining portion is emitted into the inside of the aircraft.

The electromagnetic wave W1 further enters the interior material 21 (here, the wall panel 201). The electromagnetic wave W1 is thereby partly absorbed by the medium 21A of the interior material 21. A remaining portion that is transmitted through the medium 21A enters the skin 101. The electromagnetic wave W1 is reflected toward the aircraft inner side by the skin 101 (made of aluminum alloy or CFRP) that is a conductor, and enters the interior material 21. The electromagnetic wave W1 is partly absorbed by the medium 21A again, and a remaining portion is emitted into the inside of the aircraft.

In the above path of the electromagnetic wave W1, the electromagnetic wave W1 is attenuated by a reflection loss and an absorption loss (a sum of a dielectric loss, a magnetic loss, and an electrically-conductive loss) by the media 21A and 22A every time the electromagnetic wave W1 is reflected. The electromagnetic wave W1 is mainly attenuated by the absorption loss.

The medium 21A of the interior material 21 may be formed on a back surface (a surface on an aircraft outer side) of the interior material 21. In this case, the electromagnetic wave W1 is absorbed by the medium 21A twice in a forward way and a backward way every time the electromagnetic wave W1 is reflected by the skin 101 similarly to the above description. Of course, it is more preferable that the medium 21A is formed on both of the front surface and the back surface of the interior material 21 in view of the attenuation of the electromagnetic wave.

On the other hand, since the base material of the floor panel 25 is a conductor, the medium 22A of the floor material 22 needs to be positioned on the front surface portion of the floor panel 25 such that the electromagnetic wave enters the floor panel 25 without being blocked by the base material.

Electromagnetic energy of the electromagnetic wave radiated from each of the onboard PEDs 30 is converted into thermal energy by the media 21A and 22A and is thereby lost while the electromagnetic wave is reflected, for example, two or three times by the skin 101 and the floor panel 25. Therefore, a resonance phenomenon due to the electromagnetic wave inside the aircraft can be suppressed.

Accordingly, since an interference path loss based on the absorption loss in the interior material 21 and the floor material 22 is large, it is possible to avoid the front door coupling to the outboard antenna 13 due to the electromagnetic wave leaking out of the aircraft through the opening portions such as the windows 16.

If the interior material 21 and the floor material 22 do not include the media 21A and 22A that absorb the electromagnetic waves, the electromagnetic wave W1 is transmitted through the interior material 21 made of GFRP that is a non-conductor almost without a loss, is reflected by the skin 101, and is also reflected by the floor panel 25. Since an interference path loss based on only the reflection loss is small, the electromagnetic wave W1 is repetitively reflected in the fuselage 10 until the energy is attenuated. Accordingly, resonance occurs in the fuselage 10 by the electromagnetic wave radiated from each of the PEDs 30, so that the risk of the front door coupling is increased.

Although the inhibition of the front door coupling has been described above, the interior material 21 and the floor material 22 of the present embodiment can also contribute to inhibition of the back door coupling by radiation.

That is, since the interior material 21 or the floor material 22 exists in both of a radiation interference path from the PEDs 30 to the mounted electronic devices including the computer device 141 of the communication system 14 and the computer device 151 of the navigation system 15, and a radiation interference path from the PEDs 30 to the cables 27, losses in both of the interference paths can also be increased. Therefore, stable power supply can be ensured, and the mounted devices and the cables can be protected by reducing signal noise and keeping the field intensity in a tolerant range.

Of course, the interior material 21 and the floor material 22 of the present embodiment can also contribute to stabilization of operations of the onboard PEDs 30.

As the media 21A and 22A included in the interior material 21 and the floor material 22, not only the thin film described above, but a sheet material containing ferrite, soft-magnetic metal, or carbon, or the like may also be used.

Alternatively, magnetic fine particles or the like that absorb the electromagnetic wave may be added to the GFRP material of the interior material 21 and the CFRP material of the floor panel 25.

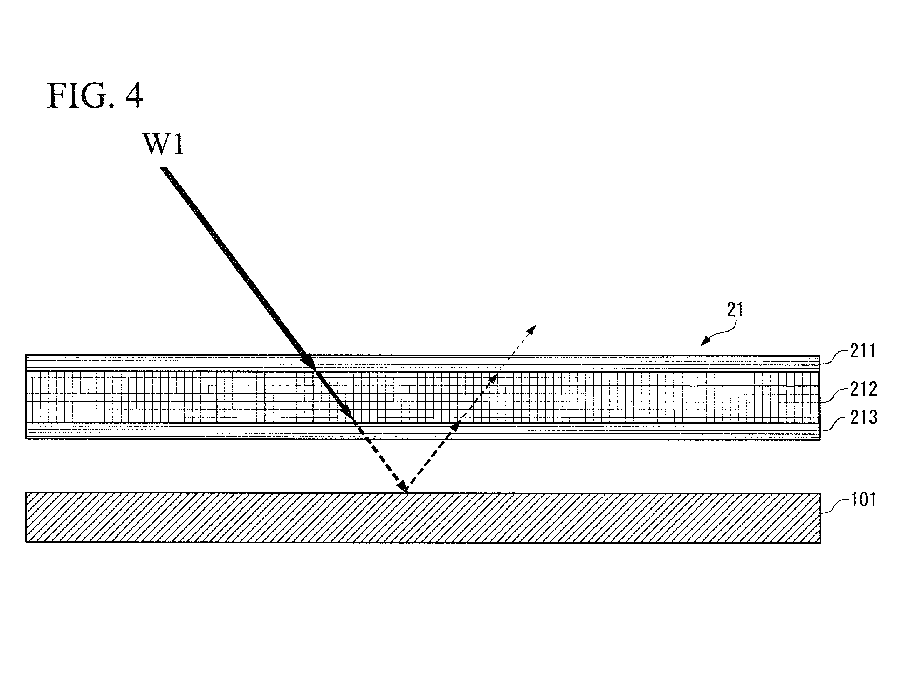

As the interior material 21 (the wall panel 201 and the ceiling panel 202), a sandwich structure in which a core 212 is sandwiched between skins as shown in FIG. 4 may also be employed.

The interior material 21 shown in FIG. 4 includes an inner skin 211 that is disposed on the aircraft inner side, the core 212, and an outer skin 213 that is disposed on the aircraft outer side.

The inner skin 211 and the outer skin 213 are formed of GFRP.

The core 212 has a honeycomb core structure that is an aggregate of polygonal cells. As a material of the core 212, GFRP, aromatic polyamide resin, polyimide, or the like can be used.

Fine particles of carbon or ferrite as the medium 21A are mixed into the materials of the core 212 and the outer skin 213 at a predetermined mixture ratio. The core 212 and the outer skin 213 absorb the electromagnetic wave by the medium 21A.

The mixture ratios of carbon or ferrite into the core 212 and the outer skin 213 may be the same as or different from each other.

On the other hand, fine particles of carbon or ferrite are not mixed into the material of the inner skin 211. That is, a mixture ratio of the medium 21A is 0. The inner skin 211 transmits the electromagnetic wave. Accordingly, the electromagnetic wave can be more sufficiently caused to enter the core 212 in which a high electromagnetic wave absorption effect is obtained by multiple reflections.

The electromagnetic wave W1 radiated from the PED 30 and entering the inner skin 211 is transmitted through the inner skin 211 to be introduced into the core 212. The electromagnetic wave W1 is absorbed by the core 212 and the outer skin 213 next to the core 212, and is then reflected toward the aircraft inner side by the skin 101. The electromagnetic wave W1 is absorbed by the outer skin 213 and the core 212 again, transmitted through the inner skin 211, and emitted into the inside of the aircraft.

By using the interior material 21 having the sandwich structure, the interference path loss can also be increased by the electromagnetic wave absorption actions of the core 212 and the outer skin 213.

By individually setting the mixture ratios of the fine particles of the medium 21A into the inner skin 211, the core 212, and the outer skin 213 as described above, the respective layers can be individually provided with a function of transmitting the electromagnetic wave and a function of absorbing the electromagnetic wave.

It is allowed that the fine particles of the medium 21A are mixed into only the core 212, and are not mixed into the outer skin 213.

It is also allowed that the fine particles of the medium 21A are also mixed into the inner skin 211 only by a small amount.

In brief, the mixture ratios of the medium 21A are preferably individually set for the respective layers such that a desired absorption effect for the electromagnetic wave entering from the inside of the aircraft can be obtained in the entire sandwich structure.

As a modification of the structure shown in FIG. 4, the outer skin 213 may be formed of, for example, CFRP. Accordingly, the outer skin 213 can reflect the electromagnetic wave.

In this case, the electromagnetic wave W1 absorbed by the core 212 is reflected toward the aircraft inner side by the outer skin 213. The electromagnetic wave W1 is absorbed by the core 212 again similarly to the above description.

As for the floor material 22, the medium 22A that absorbs the electromagnetic wave may be applied to the floor carpet 26, not the floor panel 25. Alternatively, the medium 22A may be applied to both of the floor panel 25 and the floor carpet 26. Moreover, as long as strength and stiffness can be ensured, the medium 22A may also be applied to the floor beams 23 and the seat rails 241.

To apply the medium 22A to the floor carpet 26, for example, particles of ferrite, soft-magnetic metal, or carbon may be mixed into fibers of the floor carpet 26.

In a case in which the interior material 21 has a liner formed of GFRP and a fabric covering a surface of the liner, the fabric can contain particles similar to those described above.

Forms of the media 21A and 22A can be appropriately determined in consideration of a weight as well. Ideally, the media 21A and 22A entirely cover walls and floors of the respective compartments such as the cabin 11 and the cockpit 12 such that no slot through which the electromagnetic wave is transmitted is formed in the interior material 21 and the floor material 22.

As a member to which the medium that absorbs the electromagnetic wave is applied, equipment disposed in a space inside the aircraft can also be used. For example, particles of ferrite, soft-magnetic metal, or carbon can be mixed into exteriors (including a fabric) of the seats 24, and a curtain that partitions a cabin space by seat class.

It is also effective to apply the medium that absorbs the electromagnetic wave to tables attached to the seats 24, a luggage storage bin (not shown) positioned above passengers seated in the seats 24, or the like.

Although the cabin 11 and the cockpit 12 have been described as examples of the compartment in which the medium that absorbs the electromagnetic wave is applied to the interior material 21 and the floor material 22 inside the aircraft, and the indoor equipment in the present embodiment, a similar medium can also be applied to an interior material and a floor material of the cargo compartment.

It is preferable to install an electromagnetic shielding layer or give electrical conductivity to a seal member in an opening portion such as a door of the cargo compartment in order to prevent entrance of electromagnetic waves radiated from outside into the aircraft.

An RFID (radio frequency identification) tag that actively generates an electric wave is sometimes attached to cargo loaded into the cargo compartment. The RFID generates a potential risk of electromagnetic interference similarly to the PEDs 30. A certain effect of avoiding the front door coupling of an electromagnetic wave radiated from the RFID in the cargo compartment is obtained by the electromagnetic shield or the like in the door of the cargo compartment. However, since the cargo compartment is electromagnetically closed by the electromagnetic shield or the like, cavity resonance may occur in a worst case. Thus, it is effective to absorb and attenuate the electromagnetic wave by the medium included in the interior material, the floor material, or the like in the cargo compartment in order to inhibit the front door coupling and the back door coupling.

Similar countermeasures may also be taken for a crew rest room, a galley, a toilet or the like.

### [Second Embodiment]

In the first embodiment described above, the countermeasures for inhibiting the front door coupling and the back door coupling generated when the electromagnetic waves emitted from the PEDs 30 propagate by radiation have been described.

In a second embodiment, countermeasures for inhibiting coupling generated when the electromagnetic waves emitted from the PEDs 30 that are connected to the airframe are conducted will be further described.

The aircraft 1 according to the second embodiment also includes the interior material 21 including the medium 21A and the floor material 22 including the medium 22A as shown in FIG. 1. The media 21A and 22A can inhibit the electromagnetic interference by the electromagnetic waves radiated from the PEDs 30 as described above.

As shown in FIG. 1, the plurality of cables 27 that include the power supply line and the signal transmission line are laid below the onboard floor material 22.

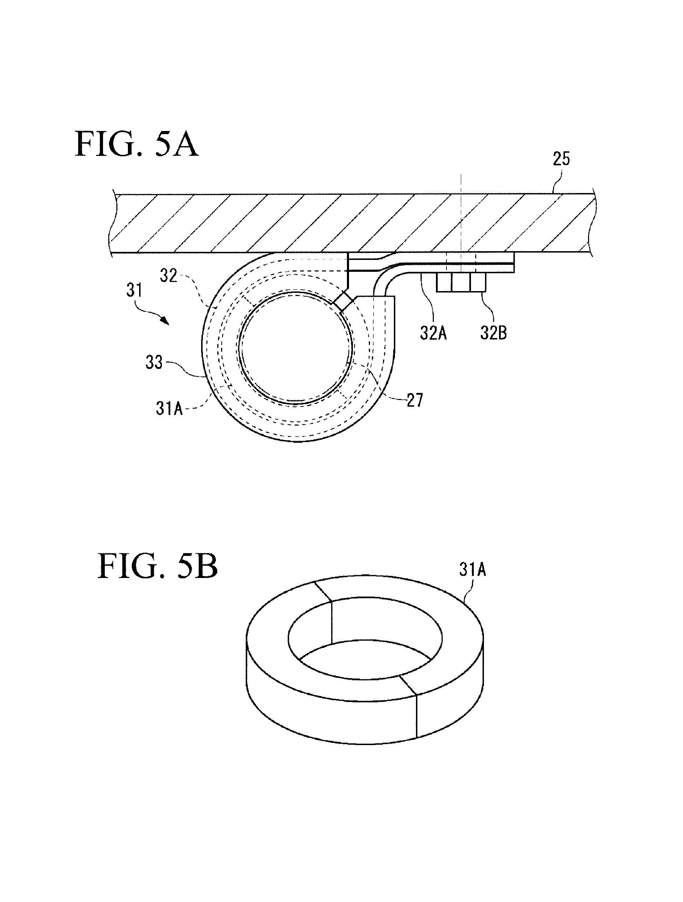

Each of the cables 27 is composed of a single or a plurality of electric wires (not shown), and is held by a clamp 31 shown in FIG. 5A. A plurality of clamps 31 are provided at intervals in a length direction of the cable 27. Each of the clamps 31 is fixed to the floor panel 25 directly or via a bracket (not shown).

In the present embodiment, the clamp 31 has a function of absorbing electromagnetic waves.

The clamp 31 includes a P-shaped clamp body 32 that is formed of a metal material such as aluminum alloy and stainless steel, or a fiber reinforced resin, an annular core 31A (FIG. 5B) that is disposed inside the clamp body 32, and a resin cover 33 that covers the clamp body 32 and the core 31A.

The clamp 31 is fastened to the floor panel 25 by a bolt 32B that passes through a tab 32A of the clamp body 32.

The cover 33 having flexibility protects the cable 27 tightened by the clamp body 32 from wear and damage. The cover 33 is also useful when vibrations are applied to the cable 27.

The cover 33 also protects the core 31A.

The cover 33 covers an annular portion excluding the tab 32A of the clamp body 32, and the entire core 31A.

The core 31A absorbs an electromagnetic wave in a high-frequency band of, for example, 100 MHz or more. As a material of the core 31A, a ferromagnetic material represented by ferrite can be suitably used. Ferrite is used for the core 31A of the present embodiment. The core 31A formed of ferrite reduces the electromagnetic wave conducted through the cable 27 since impedance becomes high in a frequency band higher than about several tens MHz.

The core 31A is divided into two portions, which are disposed so as to surround an outer peripheral portion of the cable 27.

Electromagnetic waves that include clock signals and control signals used in the PEDs 30, such as a PC, that are wire-connected to the power outlet 29 provided around the seat 24, and unnecessary emissions secondarily generated from the clock signals and the control signals are conducted to the power supply line that supplies electric power to the power outlet 29, or to another electric wire held by the same clamp 31 as that of the power supply line. Since the electromagnetic waves are absorbed by the core 31A included in the cover 33 of the clamp 31, electrostatic coupling and magnetic field coupling of the electromagnetic waves to the cables 27 can be avoided.

Therefore, it is possible to stably supply electric power to the mounted devices without generating noise in the power supply line and the signal transmission line to which the electromagnetic waves are conducted from the PEDs 30, and it is also possible to ensure a communication quality.

The clamp 31 is not limited to the P shape, and any form may be employed.

While all the clamps 31 that hold the cables 27 can be provided with the electromagnetic wave absorbing function, the electromagnetic wave absorbing function can be given at positions where the conduction coupling easily occurs due to a reason that the cable 27 is located close to the power outlet 29 or the like, or to only the clamp 31 that holds the cable 27 in which an electric wire that more largely affects flight safety when the conduction coupling occurs is included.

When only some of the clamps 31 are provided with the electromagnetic wave absorbing function, the clamp 31 that is not provided with the electromagnetic wave absorbing function may be composed of only the clamp body 32 and the cover 33 without providing the core 31A. Accordingly, a cost, a weight or the like can be suppressed.

When it becomes necessary to perform antinoise measures on a portion of the cable 27 or some of electric wires after the cable 27 is laid in the airframe, the core 31A may be disposed along the outer peripheral portion of the cable 27 at a position of the clamp 31 that is positioned at the relevant portion or that holds the electric wires.

The configurations described in the aforementioned embodiments may also be freely selected or appropriately changed into other configurations without departing from the gist of the present invention.

As long as the medium absorbs the electromagnetic wave in a predetermined high-frequency band corresponding to that of the electronic devices carried onboard, an appropriate material including those provided in future can be used as the medium of the present invention.

As the medium that absorbs the electromagnetic waves radiated from the electronic devices carried onboard, a material such as a carbon nanocoil, a carbon micro coil, and a carbon nanotube can also be employed.

The present invention can be widely applied to transport machines such as ships, trains, and buses in addition to the aircraft.

## Claims

1. A transport machine comprising a compartment into which an electronic device that generates an electromagnetic wave is carried,
wherein an intra-compartment member that is at least one of a member defining an inside of the compartment and a member disposed in the compartment includes
an interior material that constitutes an inner wall of the compartment, and
a floor material that constitutes a floor of the compartment or is provided on the floor, and
at least one of the interior material and the floor material includes a medium that absorbs the electromagnetic wave.

2. The transport machine according to claim 1, wherein
the transport machine is an aircraft, and
an airframe of the aircraft includes the compartment.

3. The transport machine according to claim 1 or claim 2,
wherein both of the interior material and the floor material include the medium, and
a space in the compartment is surrounded by the medium included in the interior material and the floor material.

4. The transport machine according to any one of claims 1 to 3,
wherein the medium contains ferrite or carbon.

5. The transport machine according to claim 2,
wherein the airframe includes
an opening defining member that defines an opening communicating with an outside of the aircraft, and
an electromagnetic shielding member that is disposed in the opening to block the electromagnetic wave.

6. The transport machine according to claim 2,
wherein the airframe includes
an opening defining member that defines an opening communicating with an outside of the aircraft,
a closing member that closes the opening, and
a seal member that is interposed between the closing member and the opening defining member, and
the seal member is given electrical conductivity.

7. The transport machine according to claim 2,
wherein the compartment includes one or more compartments selected from a cabin in which a passenger stays, an aisle through which a passenger and a crew pass, a cockpit in which a pilot controls the aircraft, and a cargo compartment into which cargo is loaded.

8. The transport machine according to claim 2,
wherein a skin in an airframe structure disposed outside the interior material is a conductor formed by using a metal material or a fiber reinforced resin containing carbon fibers as reinforcing fibers, and
the interior material is formed by using a fiber reinforced resin containing glass fibers as reinforcing fibers, and includes the medium.

9. The transport machine according to any one of claims 1 to 8,
wherein the interior material has a sandwich structure,
the sandwich structure includes
a first layer,
a second layer that is disposed outside the first layer, and
a third layer that is disposed outside the second layer,
the first layer transmits the electromagnetic wave, and
at least the second layer out of the second and third layers includes the medium and absorbs the electromagnetic wave.

10. The transport machine according to claim 9,
wherein the third layer reflects the electromagnetic wave.

11. The transport machine according to claim 9 or 10,
wherein the medium contains ferrite or carbon, and
mixture ratios of fine particles of the ferrite or the carbon are individually set for the first layer, the second layer, and the third layer.

12. The transport machine according to any one of claims 1 to 11,
wherein the floor material includes a floor panel that is formed as a sandwich panel by using a fiber reinforced resin containing carbon fibers as reinforcing fibers, and
a surface portion positioned inside the compartment in the floor panel includes the medium.

13. The transport machine according to claim 2,
wherein the airframe includes
a cable to which the electronic device is connected,
a clamp that holds the cable, and
a medium that is provided inside the clamp to absorb the electromagnetic wave.

14. The transport machine according to any one of claims 1 to 13,
wherein the floor material includes the medium, and
the floor material is a floor panel constituting the floor, or a floor mat or a floor carpet provided on the floor.
